# EUROPEAN PATENT APPLICATION

(11) **EP 4 621 849 A1**
(43) Date of publication of application: **24.09.2025**
(21) Application number: 23891364.4
(22) Date of filing: 01.11.2023
(51) Int. Cl.: H01L 27/146, G01T 1/20, H01L 27/144, H01L 31/10

(54) **PHOTOELECTRIC CONVERSION SUBSTRATE, RADIATION DETECTION PANEL, AND RADIATION DETECTION MODULE**

(30) Priority: 18.11.2022 JP 2022184689; 02.10.2023 JP 2023171334
(71) Applicant: Canon Electron Tubes & Devices Co., Ltd., Otawara-shi, Tochigi 324-0036 (JP)
(72) Inventor: HONZAWA, Keita, Otawara-shi, Tochigi 324-0036 (JP); AIDA, Hiroshi, Otawara-shi, Tochigi 324-0036 (JP)
(74) Representative: Henkel & Partner mbB
(86) International application number: PCT/JP2023/039525
(87) International publication number: WO 2024/106211

(57) **Abstract**

Provided are a photoelectric conversion substrate, a radiation detection panel, and a radiation detection module that can make uniform the photoelectric conversion efficiency of a plurality of first thin-film photodiodes.

A photoelectric conversion substrate (2) comprises a base material (2a), a plurality of gate lines (G), a plurality of data lines (T), a plurality of first thin-film transistors (13a) located in an effective area (DA), a plurality of first thin-film photodiodes (15a) located in the effective area, a plurality of second thin-film photodiodes (15b) located in a non-effective area (UA), and a plurality of second thin-film transistors (13c) located in a correction area (CA). Each of the second thin-film transistors is electrically connected to one corresponding gate line and one corresponding data line.

## Description

### Technical Field

Embodiments described herein relate generally to a photoelectric conversion substrate, a radiation detection panel, and a radiation detection module.

### Background Art

As a radiation detector, for example, an X-ray detector (X-ray flat panel detector) is known. An X-ray detection module of the X-ray detector comprises a scintillator layer that converts X-rays into fluorescence, and a photoelectric conversion substrate that converts the fluorescence into an electrical signal. The photoelectric conversion substrate comprises a plurality of photodiodes configured to convert light (fluorescence) into an electric charge.

### Citation List

### Patent Literatures

Patent Literature 1: JP 2003-46075 A
Patent Literature 2: JP 2002-199289 A
Patent Literature 3: JP 2016-72340 A

### Summary of Invention

### Technical Problem

Embodiments described herein aim to provide a photoelectric conversion substrate, a radiation detection panel, and a radiation detection module capable of equalizing photoelectric conversion efficiency of a plurality of first thin-film photodiodes.

### Solution to Problem

According to one embodiment, there is provided a photoelectric conversion substrate comprising: a basement located in an effective area which is effective for detection of radiation, a frame-shaped non-effective area surrounding the effective area, and a correction area outside the non-effective area; a plurality of gate lines provided above the basement and extending in a first direction; a plurality of data lines provided above the basement, intersecting the plurality of gate lines, and extending in the second direction; a plurality of first thin film transistors provided above the basement and located in the effective area, each of the first thin film transistors being electrically connected to one corresponding gate line of the plurality of gate lines and one corresponding data line of the plurality of data lines; a plurality of first thin film photodiodes provided above the basement and located in the effective area, each of the plurality of first thin film photodiodes being electrically connected to one corresponding first thin film transistor of the plurality of first thin film transistors; a plurality of second thin film photodiodes provided above the basement and located in the non-effective area; and a plurality of second thin film transistors provided above the basement and located in the correction area, each of the second thin film transistors being electrically connected to one corresponding gate line of the plurality of gate lines and one corresponding data line of the plurality of data lines.

According to another embodiment, there is provided a radiation detection panel comprising: a photoelectric conversion substrate; and a scintillator layer, wherein the photoelectric conversion substrate includes: a basement located in an effective area which is effective for detection of radiation, a frame-shaped non-effective area surrounding the effective area, and a correction area outside the non-effective area; a plurality of gate lines provided above the basement and extending in a first direction; a plurality of data lines provided above the basement, intersecting the plurality of gate lines, and extending in the second direction; a plurality of first thin film transistors provided above the basement and located in the effective area, each of the first thin film transistors being electrically connected to one corresponding gate line of the plurality of gate lines and one corresponding data line of the plurality of data lines; a plurality of first thin film photodiodes provided above the basement and located in the effective area, each of the plurality of first thin film photodiodes being electrically connected to one corresponding first thin film transistor of the plurality of first thin film transistors; a plurality of second thin film photodiodes provided above the basement and located in the non-effective area; and a plurality of second thin film transistors provided above the basement and located in the correction area, each of the second thin film transistors being electrically connected to one corresponding gate line of the plurality of gate lines and one corresponding data line of the plurality of data lines, and the scintillator layer is provided on the photoelectric conversion substrate and is located in the effective area.

According to yet another embodiment, there is provided a radiation detection module comprising: a photoelectric conversion substrate; a drive circuit; and a detection circuit, wherein the photoelectric conversion substrate includes: a basement located in an effective area which is effective for detection of radiation, a frame-shaped non-effective area surrounding the effective area, and a correction area outside the non-effective area; a plurality of gate lines provided above the basement and extending in a first direction; a plurality of data lines provided above the basement, intersecting the plurality of gate lines, and extending in the second direction; a plurality of first thin film transistors provided above the basement and located in the effective area, each of the first thin film transistors being electrically connected to one corresponding gate line of the plurality of gate lines and one corresponding data line of the plurality of data lines; a plurality of first thin film photodiodes provided above the basement and located in the effective area, each of the plurality of first thin film photodiodes being electrically connected to one corresponding first thin film transistor of the plurality of first thin film transistors; a plurality of second thin film photodiodes provided above the basement and located in the non-effective area; and a plurality of second thin film transistors provided above the basement and located in the correction area, each of the second thin film transistors being electrically connected to one corresponding gate line of the plurality of gate lines and one corresponding data line of the plurality of data lines, the drive circuit is electrically connected to at least a plurality of gate lines in the effective area, among the plurality of gate lines, and supplies control signals to the plurality of gate lines located in the effective area, the detection circuit is electrically connected to at least a plurality of data lines located in the effective area, among the plurality of data lines, and receives image data signals based on electric charges converted at the plurality of first thin film photodiodes, and the plurality of second thin film transistors comprise a function of correcting the image data signals.

### Brief Description of Drawings

FIG. 1 is a cross-sectional view showing an X-ray detector according to a first embodiment.
FIG. 2 is a perspective view showing a support board, an X-ray detection panel, a circuit board, a plurality of FPC, and an image transmission unit of the X-ray detector.
FIG. 3 is an enlarged cross-sectional view showing a part of the X-ray detection panel.
FIG. 4 is a circuit diagram showing the X-ray detection panel, the circuit board, and a plurality of FPC.
FIG. 5 is a plan view showing the X-ray detection panel, illustrating a positional relationship between an effective area and a scintillator layer and the like.
FIG. 6 is a cross-sectional view showing the X-ray detection panel along line VI-VI, together with FPC.
FIG. 7 is a plan view showing a photoelectric conversion substrate of the X-ray detection panel, illustrating a positional relationship between a plurality of areas.
FIG. 8 is a circuit diagram showing the photoelectric conversion substrate and the circuit board of the X-ray detector, illustrating an effective area, a first non-effective area, a third non-effective area, a fifth non-effective area, a ninth non-effective area, a first correction area, and the like.
FIG. 9 is another circuit diagram showing the photoelectric conversion substrate of the X-ray detector, illustrating an effective area, a second non-effective area, a third non-effective area, a seventh non-effective area, an eleventh non-effective area, a second correction area, and the like.
FIG. 10 is another circuit diagram showing the photoelectric conversion substrate and the circuit board of the X-ray detector, illustrating an effective area, a first non-effective area, a fourth non-effective area, a sixth non-effective area, a tenth non-effective area, a first correction area, and the like.
FIG. 11 is another circuit diagram showing the photoelectric conversion substrate and the circuit board of the X-ray detector, illustrating an effective area, a second non-effective area, a fourth non-effective area, an eighth non-effective area, a twelfth non-effective area, a second correction area, and the like.
FIG. 12 is a view illustrating a method of manufacturing a photoelectric conversion substrate according to the first embodiment, and is a cross-sectional view showing a basement, an underlayer, a plurality of conductive layers, a laminate, and a plurality of resist masks.
FIG. 13 is a view illustrating the manufacturing method, following FIG. 12, and is a cross-sectional view showing a basement, an underlayer, a plurality of conductive layers, and a plurality of thin-film photodiodes.
FIG. 14 is a plan view showing a photoelectric conversion substrate of an X-ray detection panel according to a modified example of the first embodiment, illustrating a positional relationship between a plurality of areas.
FIG. 15 is a plan view showing a photoelectric conversion substrate of an X-ray detection panel according to a second embodiment, illustrating a positional relationship between a plurality of areas.
FIG. 16 is a circuit diagram showing the photoelectric conversion substrate and the circuit board of the X-ray detector according to the second embodiment, illustrating an effective area, a first non-effective area, a third non-effective area, a fifth non-effective area, a thirteenth non-effective area, a third correction area, and the like.
FIG. 17 is another circuit diagram showing the photoelectric conversion substrate and the circuit board of the X-ray detector according to the second embodiment, illustrating an effective area, a first non-effective area, a fourth non-effective area, a sixth non-effective area, a fifteenth non-effective area, a fourth correction area, and the like.
FIG. 18 is a plan view showing a photoelectric conversion substrate of an X-ray detection panel according to a modified example of the second embodiment, illustrating a positional relationship between a plurality of areas.
FIG. 19 is a plan view showing a photoelectric conversion substrate of an X-ray detection panel according to a third embodiment, illustrating a positional relationship between a plurality of areas.
FIG. 20 is a plan view showing a photoelectric conversion substrate of an X-ray detection panel according to a modified example of the third embodiment, illustrating a positional relationship between a plurality of areas.

Mode for Carrying Out the Invention Embodiments and modified examples will be described hereinafter with reference to the accompanying drawings.

### (First Embodiment)

First, a configuration of an X-ray detector 1 and a method of manufacturing the X-ray detector 1 according to a first embodiment will be described.

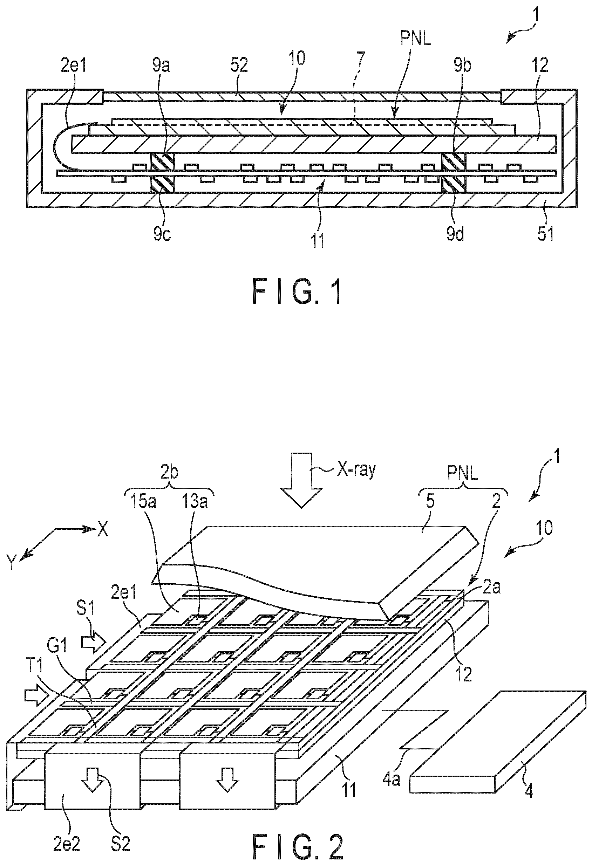

FIG. 1 is a cross-sectional view showing the X-ray detector 1 according to the first embodiment. The X-ray detector 1 is an X-ray image detector, and is an X-ray flat panel detector using an X-ray detection panel. The X-ray detector 1 is used for, for example, general medical purposes and the like.

As shown in FIG. 1, the X-ray detector 1 comprises an X-ray detection module 10, a support board 12, spacers 9a, 9b, 9c, and 9d, a housing 51, an incident window 52, and the like. The X-ray detection module 10 comprises an X-ray detection panel PNL, a circuit board 11, a flexible printed circuit (FPC) 2e1, and the like. The X-ray detection panel PNL is located between the support board 12 and the incident window 52. The X-ray detection panel PNL comprises a moisture-proof cover 7 facing the incident window 52.

The incident window 52 is attached to an opening of the housing 51. The incident window 52 transmits X-rays. For this reason, the X-rays are transmitted through the incident window 52 and are made incident on the X-ray detection panel PNL. The incident window 52 is formed in a plate shape and comprises a function of protecting the inside of the housing 51. The incident window 52 is desirably formed of a material with a low X-ray absorption rate and formed to be thin. The scattering of the X-rays and the attenuation of the amount of X-rays, which occur at the incident window 52, can be thereby reduced. Then, a thin and lightweight X-ray detector 1 can be realized.

The X-ray detection module 10, the support board 12, and the like are housed inside a space surrounded by the housing 51 and the incident window 52.

Since the X-ray detection panel PNL is constructed by stacking thin members, the panel is lightweight and has a low mechanical strength. For this reason, the X-ray detection panel PNL is fixed to one flat surface of the support board 12 via an adhesive sheet. The support board 12 is formed of, for example, an aluminum alloy, in a plate shape, and has a strength necessary to stably hold the X-ray detection panel PNL. It is thereby possible to suppress damage to the X-ray detection panel PNL when vibration or shock is applied to the X-ray detector 1 from the outside.

The circuit board 11 is fixed to the other surface of the support board 12 via the spacers 9a and 9b. By using the spacers 9a and 9b, an electrical insulation distance between the support board 12, which is mainly formed of metal, and the circuit board 11 can be maintained.

The circuit board 11 is fixed to the inner surface of the housing 51 via the spacers 9c and 9d. By using the spacers 9c and 9d, an electrical insulation distance between the housing 51, which is mainly formed of metal, and the circuit board 11 can be maintained. The housing 51 supports the support board 12 and the like via the circuit board 11 and the spacers 9a, 9b, 9c, and 9d.

A connector corresponding to the FPC 2e1 is mounted on the circuit board 11, and the FPC 2e1 is electrically connected to the circuit board 11 via the connector. A thermocompression bonding method using an anisotropic conductive film (ACF) is used to connect the FPC 2e1 with the X-ray detection panel PNL. The electrical connection between a plurality of fine pads of the X-ray detection panel PNL and a plurality of fine pads of the FPC 2e1 is ensured, and the FPC 2e1 is physically fixed to the X-ray detection panel PNL, by this method. Incidentally, the pads of the X-ray detection panel PNL will be described later.

As described above, the circuit board 11 is electrically connected to the X-ray detection panel PNL via the connector, the FPC 2e1, and the like. The circuit board 11 electrically drives the X-ray detection panel PNL and electrically processes output signals from the X-ray detection panel PNL.

FIG. 2 is a perspective view showing a support board 12, an X-ray detection panel PNL, a circuit board 11, a plurality of FPCs 2e1 and 2e2, and an image transmission unit 4 of the X-ray detector 1 according to the embodiment. FIG. 2 does not show all the members of the X-ray detector 1. Illustration of several components of the X-ray detector 1, such as the joint member to be described below, is omitted in FIG. 2. As regards the photoelectric conversion substrate 2, the effective area (effective area DA to be described below), which is the detection area, is shown, but the non-detection area (non-detection area NDA to be described below) is not shown.

As shown in FIG. 2, the X-ray detection panel PNL includes a photoelectric conversion substrate 2, a scintillator layer 5, and the like. The photoelectric conversion substrate 2 includes a basement 2a, a plurality of photoelectric conversion units 2b, a plurality of gate lines (or control lines) G1, a plurality of data lines (or signal lines) T1, and the like. Incidentally, the number, arrangement, and the like of the photoelectric conversion units 2b, the gate lines G1, the data lines T1, and the wiring boards 2e1 and 2e2 are not limited to the example in FIG. 2.

The plurality of gate lines G1 are provided above the basement 2a, extend in a row direction X as a first direction, and are spaced apart at predetermined intervals in a column direction Y that intersects with the first direction. The plurality of data lines T1 are provided above the basement 2a, extend in a column direction Y as a second direction, intersect with the plurality of gate lines G1, and are spaced apart at predetermined intervals in the row direction X.

The plurality of photoelectric conversion units 2b are provided on one surface side of the basement 2a. The photoelectric conversion units 2b are provided in quadrangular areas partitioned by the gate lines G1 and the data lines T1. One photoelectric conversion unit 2b corresponds to one pixel of an X-ray image. The plurality of photoelectric conversion units 2b are arranged in a matrix in the row direction X and the column direction Y. Based on the above, the photoelectric conversion substrate 2 is an array substrate.

Each of the photoelectric conversion units 2b includes a first thin film photodiode 15a which is a photoelectric conversion element, and a first thin film transistor 13a which is a first detection switching element. In the following descriptions, the first thin film photodiode 15a is referred to as TFD 15a, and the first thin film transistor 13a is referred to as TFT 13a. The TFT 13a is provided above the basement 2a, and is connected to a corresponding one of gate lines G1 and a corresponding one of data lines T1. The TFD 15a is provided above the basement 2a, and is electrically connected to the TFT 13a.

The gate lines G1 are electrically connected to the circuit board 11 via the FPC 2e1. The circuit board 11 supplies a control signal S1 to the plurality of gate lines G1 via the FPC 2e1. The data lines T1 are electrically connected to the circuit board 11 via the FPC 2e2. An image data signal S2 converted by the TFD 15a (i.e., an electric charge accumulated in the photoelectric conversion unit 2b) is transmitted to the circuit board 11 via the TFT 13a, the data line T1, and the FPC 2e2.

The X-ray detector 1 comprises an image transmission unit 4. The image transmission unit 4 is connected to circuit board 11 via a wiring line 4a. Incidentally, the image transmission unit 4 may be incorporated into the circuit board 11. The image transmission unit 4 generates an X-ray image, based on image data signals converted into digital signals by a plurality of analog-to-digital converters (not shown). The generated X-ray image data is output from the image transmission unit 4 to an external device.

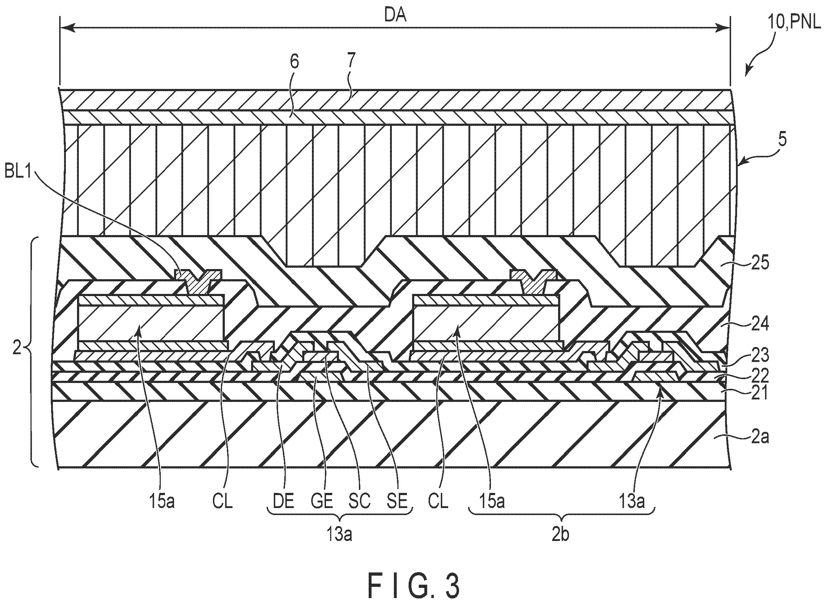

FIG. 3 is an enlarged sectional view showing a part of the X-ray detection panel PNL according to the first embodiment.

As shown in FIG. 3, the photoelectric conversion substrate 2 includes the basement 2a, the plurality of photoelectric conversion units 2b, and insulating layers 21, 22, 23, 24, and 25. The plurality of photoelectric conversion units 2b are located in the effective area DA that is effective for detection of radiation (for example, X-rays). Each of the photoelectric conversion units 2b includes the TFD 15a and the TFT 13a.

The TFT 13a includes a gate electrode GE, a semiconductor layer SC, a source electrode SE, and a drain electrode DE. The TFD 15a is composed of a thin film photodiode.

The basement 2a has a plate-like shape and is formed of an insulating material. Examples of the insulating material include glass such as alkali-free glass. In the embodiment, the basement 2a is formed of glass, but may be formed of an organic insulating material such as resin. The planar shape of the basement 2a is, for example, a quadrangle. The thickness of the basement 2a is, for example, 0.5 to 0.7 mm. The insulating layer 21 is provided on the basement 2a.

The gate electrode GE is formed on the insulating layer 21. The gate electrode GE is electrically connected to the gate line G1. The insulating layer 22 is provided on the insulating layer 21 and the gate electrode GE. The semiconductor layer SC is provided on the insulating layer 22 and faces the gate electrode GE. The semiconductor layer SC is formed of a semiconductor material such as amorphous silicon as an amorphous semiconductor and polycrystalline silicon as a polycrystalline semiconductor.

The source electrode SE and the drain electrode DE are provided on the insulating layer 22 and the semiconductor layer SC. The gate electrode GE, the source electrode SE, the drain electrode DE, the gate line G1, and the data line T1 are formed using a low-resistance metal such as aluminum or chromium.

The source electrode SE is electrically connected to a source area of the semiconductor layer SC. In addition, the source electrode SE is electrically connected to the data line T1. The drain electrode DE is electrically connected to a drain area of the semiconductor layer SC.

The insulating layer 23 is provided on the insulating layer 22, the semiconductor layer SC, the source electrode SE, and the drain electrode DE. The conductive layer CL is formed above the insulating layer 23 and is electrically connected to the drain electrode DE. The TFD 15a is formed on the conductive layer CL and is electrically connected to the conductive layer CL. The TFD 15a is formed through a film formation process and a patterning process using a dry etching method.

The insulating layer 24 is provided on the insulating layer 23, the conductive layer CL, and the TFD 15a. A bias line BL1 is provided on the insulating layer 24, and is connected to the TFD 15a through a contact hole formed in the insulating layer 24. The insulating layer 25 is provided on the insulating layer 24 and the bias line BL1.

The insulating layers 21, 22, 23, 24, and 25 are formed of an insulating material such as an inorganic insulating material or an organic insulating material. Examples of the inorganic insulating material include oxide insulating materials, nitride insulating materials, and oxynitride insulating materials. Examples of the organic insulating material include resins.

The scintillator layer 5 is provided on the photoelectric conversion substrate 2 (i.e., a plurality of photoelectric conversion units 2b). The scintillator layer 5 is located at least in the effective area DA and covers upper parts of the plurality of photoelectric conversion units 2b. The scintillator layer 5 is configured to convert incident X-rays into light (fluorescence).

Incidentally, the TFD 15a converts the light made incident from the scintillator layer 5 into an electric charge. The converted electric charge is stored in the TFD 15a. The TFT 13a can switch between storing electric charge in the TFD 15a and discharging electric charge from the TFD 15a. Incidentally, when the self-capacitance of the TFD 15a is insufficient, the photoelectric conversion substrate 2 may further include a capacitor (storage capacitor) and store the electric charge converted by the TFD 15a in the capacitor.

The scintillator layer 5 is formed of thallium-activated cesium iodide (CsI:Tl). If the scintillator layer 5 is formed using a vacuum evaporation method, the scintillator layer 5 formed of an aggregate of a plurality of columnar crystals can be obtained. The thickness of the scintillator layer 5 is, for example, 600 µm. On the outermost surface of the scintillator layer 5, the columnar crystals of the scintillator layer 5 have a thickness of 8 to 12 µm.

The material for forming the scintillator layer 5 is not limited to CsI:Tl. The scintillator layer 5 may be formed of thallium-activated sodium iodide (NaI:Tl), sodium-activated cesium iodide (CsI:Na), europium-activated cesium bromide (CsBr:Eu), sodium iodide (NaI), or the like.

Incidentally, when the scintillator layer 5 is formed using the vacuum evaporation method, a mask having an opening is used. In this case, the scintillator layer 5 is formed in the area facing the opening on the photoelectric conversion substrate 2. In addition, the scintillator material formed by vapor deposition is also deposited on the surface of the mask. Then, the scintillator material is also deposited in the vicinity of the opening of the mask, and crystals grow so as to gradually protrude into the opening. When the crystals protrude from the mask into the opening, vapor deposition of the scintillator material onto the photoelectric conversion substrate 2 in the vicinity of the opening is suppressed. Therefore, as shown in FIG. 2, the thickness of the scintillator layer 5 in the vicinity of its periphery gradually decreases toward the outside.

Alternatively, the scintillator layer 5 may include a plurality of scintillator portions arranged in a matrix, provided one-to-one on the photoelectric conversion units 2b, and each having a quadrangular prism shape. When such a scintillator layer 5 is formed, a scintillator material obtained by mixing gadolinium oxysulfide (Gd₂O₂S) phosphor particles with a binder material is applied onto the photoelectric conversion substrate 2, and the scintillator material is fired and hardened. After that, dicing is performed using a dicer to form grooves in a grating shape in the scintillator material. In the above case, air or an inert gas such as nitrogen (N₂) for preventing oxidation is sealed between the plurality of scintillator portions. Alternatively, the space between the plurality of scintillator portions may be set to a space whose pressure is lower than atmospheric pressure.

In the embodiment, the X-ray detection panel PNL further comprises a light reflective layer 6. The light reflective layer 6 is provided on the scintillator layer 5. In other words, the light reflective layer 6 is provided on the X-ray incident side of the scintillator layer 5. The light reflective layer 6 is located in at least the effective area DA and covers the upper surface of the scintillator layer 5. The light reflective layer 6 is provided to increase the efficiency of use of light (fluorescence) and improve the sensitivity characteristics. In other words, the light reflective layer 6 reflects the light that travels towards a side opposite to the side where the photoelectric conversion unit 2b is provided, of the light generated in the scintillator layer 5, such that the light travels toward the photoelectric conversion unit 2b. However, the light reflective layer 6 is not necessarily required, but may be provided in accordance with the sensitivity characteristics required for the X-ray detection panel PNL.

For example, the light reflective layer 6 can be formed by applying a coating material, which is obtained by mixing a light scattering particles of titanium oxide (TiO₂) and the like, a resin, and a solvent, onto the scintillator layer 5, and then drying the coating material.

Incidentally, the structure of the light reflective layer 6 and the method of manufacturing the light reflective layer 6 are not limited to the above examples, but can be variously modified. For example, the light reflective layer 6 may be formed by forming a layer of a metal with high light reflectance, such as a silver alloy or aluminum, on the scintillator layer 5. Alternatively, the light reflective layer 6 may be formed by providing a sheet including a metal layer whose surface has a high light reflectance, such as a silver alloy or aluminum, a resin sheet containing light scattering particles, or the like, on the scintillator layer 5.

Incidentally, when a paste-like coating material is applied onto the scintillator layer 5 and the coating material is dried, the coating material shrinks as it dries. A tensile stress may be applied to the scintillator layer 5, and the scintillator layer 5 may be peeled off from the photoelectric conversion substrate 2. For this reason, the sheet-like light reflective layer 6 is desirably provided on the scintillator layer 5. In this case, the light reflective layer 6 can be bonded onto the scintillator layer 5 using, for example, a double-sided tape, but the light reflective layer 6 is desirably mounted on the scintillator layer 5. If the sheet-like light-reflective layer 6 is mounted on the scintillator layer 5, peeling of the scintillator layer 5 from the photoelectric conversion substrate 2 due to expansion or contraction of the light reflective layer 6 can easily be suppressed.

The moisture-proof cover (moisture-proof sheet) 7 covers the scintillator layer 5 and the light reflective layer 6. The moisture-proof cover 7 is provided to prevent the properties of the light reflective layer 6 and the scintillator layer 5 from being deteriorated due to moisture contained in air. The moisture proof cover 7 completely covers an exposed portion of the scintillator layer 5. A gap may be formed between the moisture-proof cover 7 and the light reflective layer 6 or the like or the moisture-proof cover 7 may be in contact with the light reflective layer 6 or the like.

The moisture-proof cover 7 is formed of a sheet containing metal. Examples of the metal include metals containing aluminum, metals containing copper, metals containing magnesium, metals containing tungsten, stainless steel, Kovar, and the like. When the moisture-proof cover 7 contains metal, the moisture-proof cover 7 can prevent or significantly suppress the permeation of moisture.

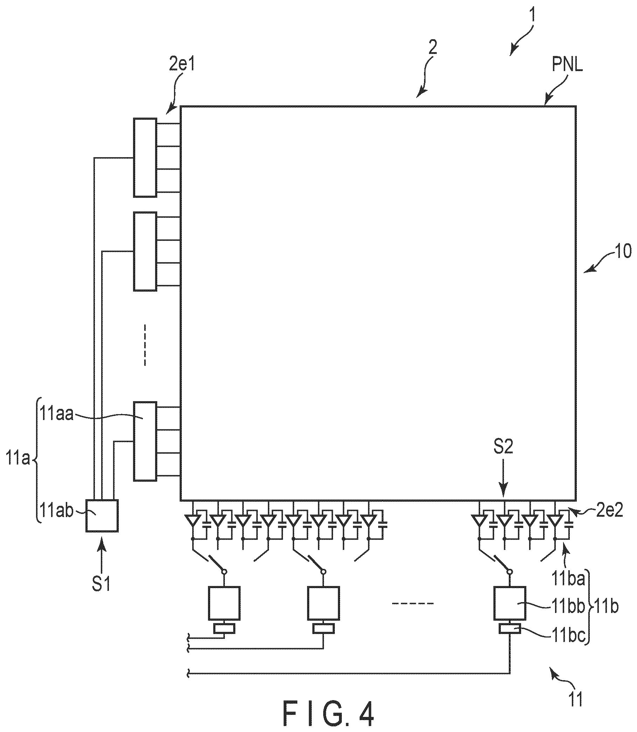

FIG. 4 is a circuit diagram showing the X-ray detection panel PNL, the circuit board 11, and the plurality of FPC 2e1 and 2e2 according to the first embodiment.

As shown in FIG. 2 to FIG. 4, a read circuit 11a serving as a drive circuit and a signal detection circuit 11b serving as a detection circuit are provided on the circuit board 11. Incidentally, these circuits can be provided on one board or these circuits can be provided separately on plurality of boards. Each of the other ends of the plurality of wiring lines provided on the FPC 2e1 is electrically connected to the read circuit 11a. Each of the other ends of the plurality of wiring lines provided on the FPC 2e2 is electrically connected to the signal detection circuit 11b.

The read circuit 11a switches an on state and an off state of the TFT 13a. The read circuit 11a includes a plurality of gate drivers 11aa and a row selection circuit 11ab. A control signal S1 is input to the row selection circuit 11ab from an image processing unit (not shown) provided outside the X-ray detector 1. The row selection circuit 11ab inputs the control signal S1 to the corresponding gate driver 11aa in accordance with the scanning direction of the X-ray image. The gate driver 11aa inputs the control signal S1 to the corresponding gate line G1.

For example, the read circuit 11a sequentially inputs the control signals S1 to the plurality of gate lines G1 via the FPC 2e1. The TFT 13a is turned on or off by the control signal S1 input to the gate line G1, and the charge (image data signal S2) from the TFD 15a is output to the FPC 2e2 by turning on the TFT 13a.

The signal detection circuit 11b includes plurality of integrating amplifiers 11ba, a plurality of selection circuits 11bb, and plurality of analog-to-digital converters (AD converters) 11bc. One integrating amplifier 11ba is electrically connected to one data line T1. The integrating amplifier 11ba sequentially receives image data signals S2 from the plurality of photoelectric conversion units 2b. Then, the integrating amplifier 11ba integrates the current flowing within a certain time and outputs a voltage corresponding to the integral value to the selection circuit 11bb. Accordingly, the value of the current (amount of charge) flowing through the data line T1 within a predetermined time can be converted into a voltage value. In other words, the integrating amplifier 11ba converts image data information corresponding to the intensity distribution of the fluorescence generated in the scintillator layer 5 into potential information.

The selection circuit 11bb selects the integrating amplifier 11ba that executes reading, and sequentially reads the image data signals S2 that have been converted into potential information. The AD converter 11bc sequentially converts the read image data signals S2 into digital signals. The image data signals S2 that have been converted into digital signals are input to the image processing unit via wiring line. Incidentally, the image data signals S2 that have been converted into digital signals may be transmitted to the image processing unit in a wireless manner. The image processing unit creates X-ray images based on the image data signals S2 that have been converted into the digital signals. Incidentally, the image processing unit may also be integrated with the circuit board 11.

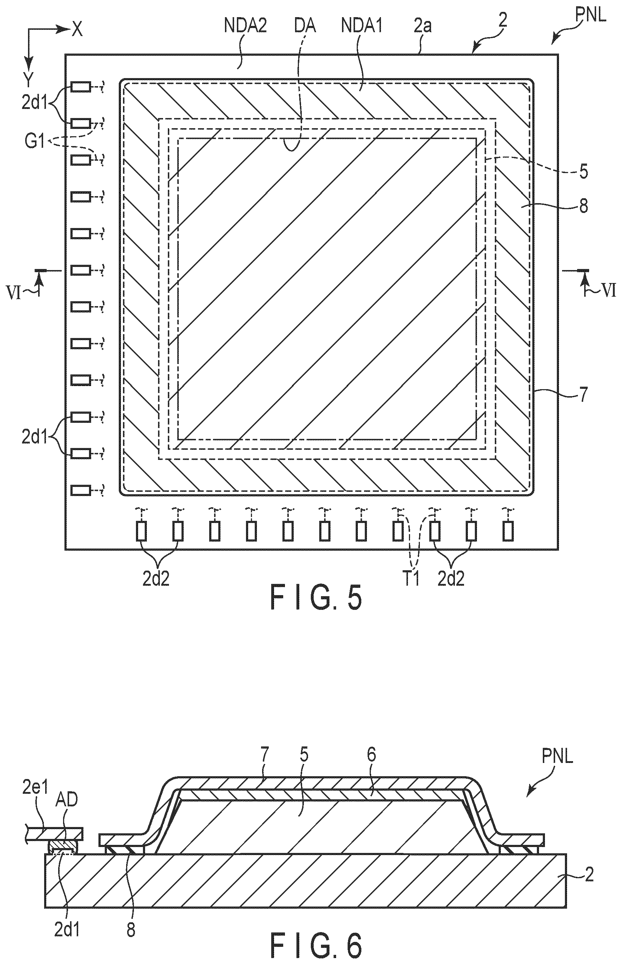

FIG. 5 is a plan view showing the X-ray detection panel PNL according to the first embodiment, illustrating a positional relationship between the effective area DA and the scintillator layer 5 or the like. In FIG. 5, the scintillator layer 5 is marked with diagonal lines rising upward to the right, and a joining member 8 is marked with diagonal lines falling downward to the right. FIG. 6 is a cross-sectional view showing the X-ray detection panel PNL according to the first embodiment, along line VI-VI, together with FPC 2e1.

As shown in FIG. 5 and FIG. 6, the photoelectric conversion substrate 2 includes an effective area DA, a frame-shaped first non-detection area NDA1 located around the effective area DA, and a second non-detection area NDA2 outside the first non-detection area NDA1. In the embodiment, the second non-detection area NDA2 has a frame shape. The basement 2a is located in the effective area DA, and the frame-shaped non-detection areas (first non-detection area NDA1 and second non-detection area NDA2) surrounding the effective area DA.

The scintillator layer 5 is located in at least the effective area DA. The photoelectric conversion substrate 2 further includes a plurality of pads 2d1 and a plurality of pads 2d2. The pads 2d1 and the pads 2d2 are located in the second non-detection area NDA2. In the embodiment, the plurality of pads 2d1 are arranged along the left side of the basement 2a, and the plurality of pads 2d2 are arranged along the bottom side of the basement 2a. Incidentally, FIG. 5 schematically shows a plurality of pads, and the number, shape, size, position, and pitch of the plurality of pads are not limited to those in the example shown in FIG. 5.

One gate line G1 extends through the effective area DA, the first non-detection area NDA1, and the second non-detection area NDA2, and is electrically connected to one of the plurality of pads 2d1. One data line T1 extends through the effective area DA, the first non-detection area NDA1, and the second non-detection area NDA2, and is electrically connected to one of the plurality of pads 2d2.

One of a plurality of wiring lines provided on the FPC 2e1 is electrically connected to one pad 2d1, and one of a plurality of wiring lines provided on the FPC 2e2 is electrically connected to one pad 2d2 (FIG. 2).

The X-ray detection panel PNL further comprises a joining member 8. The joining member 8 is provided around the scintillator layer 5. The joining member 8 has a frame-like shape and extends continuously around the scintillator layer 5. The joining member 8 is joined to the photoelectric conversion substrate 2 (for example, the above-mentioned insulating layer 25).

The moisture-proof cover 7 is provided on the photoelectric conversion substrate 2, the scintillator layer 5, and the light reflective layer 6. The moisture-proof cover 7 is located in the effective area DA and the non-detection area (first non-detection area NDA1). The moisture-proof cover 7 completely covers the scintillator layer 5 in the plan view shown in FIG. 5. As shown in FIG. 6, the portion of the scintillator layer 5, which is not covered with the photoelectric conversion substrate 2 and the joining member 8, is completely covered with the moisture-proof cover 7. The moisture-proof cover 7 is joined to the joining member 8. The moisture-proof cover 7 seals the scintillator layer 5 and the light reflective layer 6 together with the photoelectric conversion substrate 2 and the joining member 8.

For example, the moisture-proof cover 7 can be brought into contact with the light reflective layer 6 and the like if the moisture-proof cover 7 and the joining member 8 are joined in an environment in which a pressure is lower than atmospheric pressure. In addition, in general, the scintillator layer 5 includes voids of approximately 10 to 40 % of its volume. If the moisture-proof cover 7 and the joining member 8 are joined in an environment in which a pressure is lower than atmospheric pressure, damage to the moisture-proof cover 7 can be suppressed even if the X-ray detector 1 is transported by aircraft or the like. Based on the above, the pressure in the space defined by the joining member 8 and the moisture-proof cover 7 is desirably lower than the atmospheric pressure.

The joining member 8 is located between the photoelectric conversion substrate 2 and the moisture-proof cover 7, and is formed of thermoplastic resin. By heating the vicinity of the periphery of the moisture-proof cover 7, the joining member 8 joins the photoelectric conversion substrate 2 and the moisture-proof cover 7.

The FPC 2e1 is fixed to the photoelectric conversion substrate 2 (X-ray detection panel PNL) by a connection material AD, and is electrically connected to the pad 2d1. The connection material AD is formed of ACF.

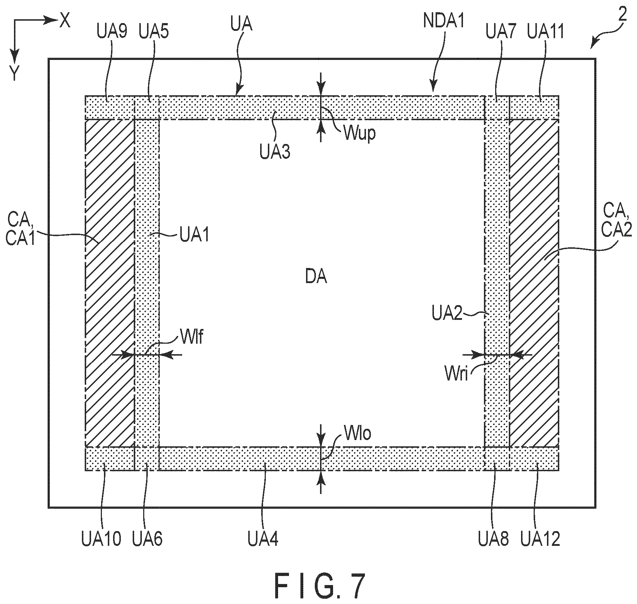

FIG. 7 is a plan view showing the photoelectric conversion substrate 2 according to the first embodiment, illustrating a positional relationship between a plurality of areas. In FIG. 7, the non-effective area UA is marked with a dot pattern, and the correction area CA is marked with diagonal lines slanting upward to the right.

As shown in FIG. 7, the non-detection area (first non-detection area NDA1) includes a non-effective area UA. The non-effective area UA is adjacent to the effective area DA of the first non-detection area NDA1. The non-effective area UA surrounds the effective area DA.

The non-effective area UA includes a first non-effective area UA1, a second non-effective area UA2, a third non-effective area UA3, a fourth non-effective area UA4, a fifth non-effective area UA5, a sixth non-effective area UA6, a seventh non-effective area UA7, and an eighth non-effective area UA8. The first non-effective area UA1 to the eighth non-effective area UA8 are frame-shaped areas.

The first non-effective area UA1 extends in the column direction Y and is adjacent to the effective area DA in the row direction X. The second non-effective area UA2 extends in the column direction Y and is adjacent to the effective area DA in the row direction X, and sandwiches the effective area DA in the row direction X together with the first non-effective area UA1. The third non-effective area UA3 extends in the row direction X and is adjacent to the effective area DA in the column direction Y. The fourth non-effective area UA4 extends in the row direction X and is adjacent to the effective area DA in the column direction Y, and sandwiches the effective area DA in the column direction Y together with the third non-effective area UA3. In the first embodiment, when the first non-effective area UA1 to the fourth non-effective area UA4 are viewed with reference to the effective area DA, the first non-effective area UA1 is located on the left side, the second non-effective area UA2 is located on the right side, the third non-effective area UA3 is located on the upper side, and the fourth non-effective area UA4 is located on the lower side.

The fifth non-effective area UA5 is adjacent to the first non-effective area UA1 in the column direction Y and is adjacent to the third non-effective area UA3 in the row direction X. The sixth non-effective area UA6 is adjacent to the first non-effective area UA1 in the column direction Y and is adjacent to the fourth non-effective area UA4 in the row direction X. The seventh non-effective area UA7 is adjacent to the second non-effective area UA2 in the column direction Y and is adjacent to the third non-effective area UA3 in the row direction X. The eighth non-effective area UA8 is adjacent to the second non-effective area UA2 in the column direction Y and is adjacent to the fourth non-effective area UA4 in the row direction X.

The non-detection area (first non-detection area NDA1) further includes a correction area CA. The correction area CA is located outside the non-effective area UA of the first non-detection area NDA1. The correction area CA includes a first correction area CA1 and a second correction area CA2. The first correction area CA1 extends in the column direction Y, is adjacent to the first non-effective area UA1 in the row direction X, and sandwiches the first non-effective area UA1 in the row direction X together with the effective area DA. The second correction area CA2 extends in the column direction Y, is adjacent to the second non-effective area UA2 in the row direction X, and sandwiches the second non-effective area UA2 in the row direction X together with the effective area DA.

The non-effective area UA further includes a ninth non-effective area UA9, a tenth non-effective area UA10, an eleventh non-effective area UA11, and a twelfth non-effective area UA12.

The ninth non-effective area UA9 is adjacent to the fifth non-effective area UA5 in the row direction X, and sandwiches the fifth non-effective area UA5 in the row direction X together with the third non-effective area UA3. The tenth non-effective area UA10 is adjacent to the sixth non-effective area UA6 in the row direction X, and sandwiches the sixth non-effective area UA6 in the row direction X together with the fourth non-effective area UA4.

The eleventh non-effective area UA11 is adjacent to the seventh non-effective area UA7 in the row direction X, and sandwiches the seventh non-effective area UA7 in the row direction X together with the third non-effective area UA3. The twelfth non-effective area UA12 is adjacent to the eighth non-effective area UA8 in the row direction X, and sandwiches the eighth non-effective area UA8 in the row direction X together with the fourth non-effective area UA4.

Incidentally, the first correction area CA1 is further adjacent to the ninth non-effective area UA9 and the tenth non-effective area UA10, and is sandwiched between the ninth non-effective area UA9 and the tenth non-effective area UA10 in the column direction Y. The second correction area CA2 is further adjacent to the eleventh non-effective area UA11 and the twelfth non-effective area UA12, and is sandwiched between the eleventh non-effective area UA11 and the twelfth non-effective area UA12 in the column direction Y.

The width in the column direction Y of each of the third non-effective area UA3, the fifth non-effective area UA5, and the seventh non-effective area UA7 is represented by Wup, the width in the column direction Y of each of the fourth non-effective area UA4, the sixth non-effective area UA6, and the eighth non-effective area UA8 is represented by Wlo, the width in the row direction X of each of the first non-effective area UA1, the fifth non-effective area UA5, and the sixth non-effective area UA6 is represented by Wlf, and the width in the row direction X of each of the second non-effective area UA2, the seventh non-effective area UA7, and the eighth non-effective area UA8 is represented by Wri.

In this embodiment, each of the width Wup, the width Wlo, the width Wlf, and the width Wri is 300 µm. However, each of the width Wup, the width Wlo, the width Wlf, and the width Wri is not limited to 300 µm, but can be variously changed.

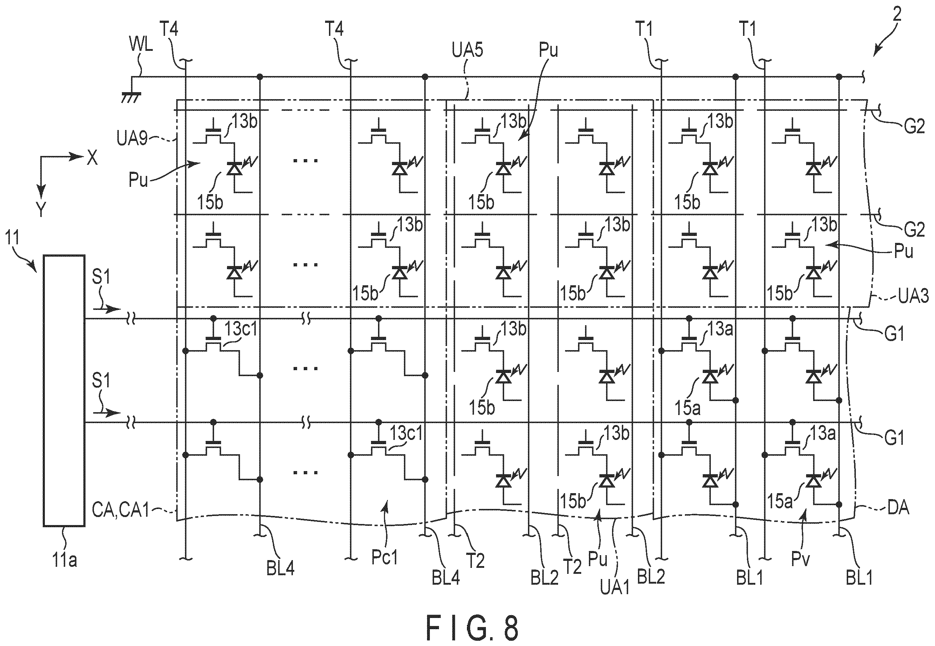

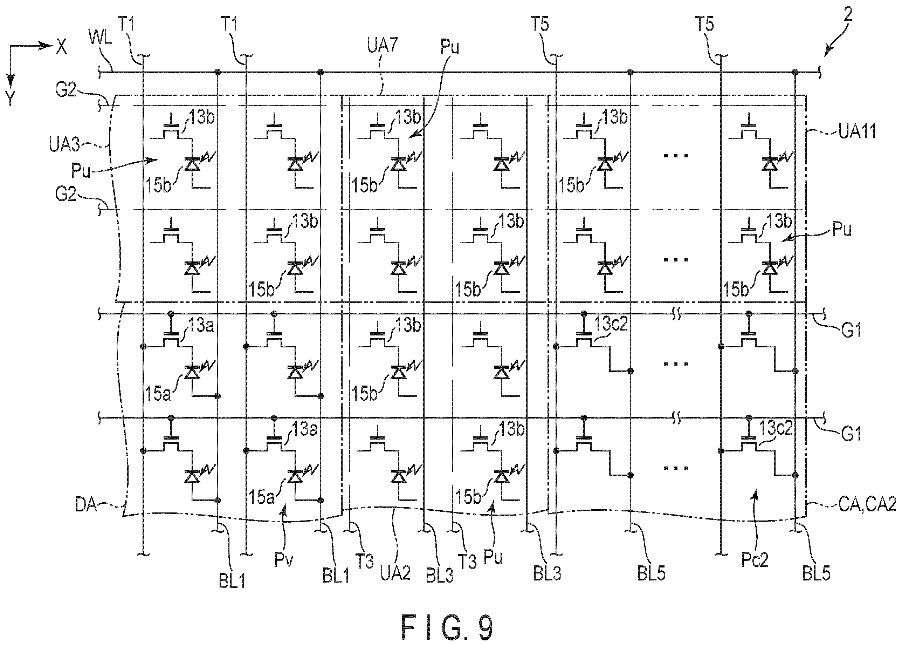

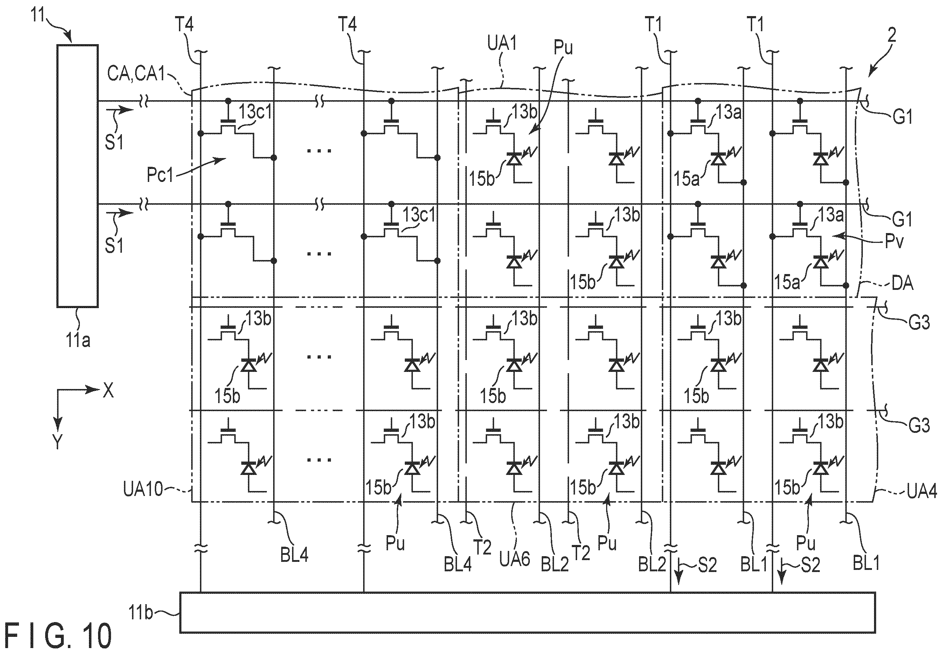

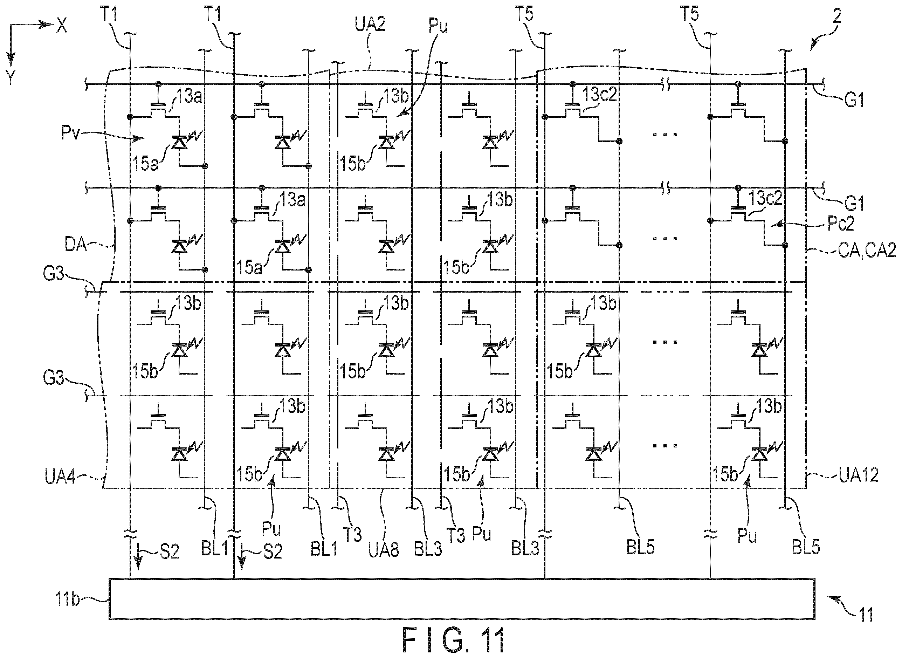

FIG. 8, FIG. 9, FIG. 10, and FIG. 11 are circuit diagrams showing the photoelectric conversion substrate 2 of the X-ray detector 1 according to the first embodiment, and FIG. 8, FIG. 10, and FIG. 11 are circuit diagrams further showing the circuit board 11. FIG. 8 is a view showing the effective area DA, the first non-effective area UA1, the third non-effective area UA3, the fifth non-effective area UA5, the ninth non-effective area UA9, the first correction area CA1, and the like. FIG. 9 is a view showing the effective area DA, the second non-effective area UA2, the third non-effective area UA3, the seventh non-effective area UA7, the eleventh non-effective area UA11, the second correction area CA2, and the like. FIG. 10 is a view showing the effective area DA, the first non-effective area UA1, the fourth non-effective area UA4, the sixth non-effective area UA6, the tenth non-effective area UA10, the first correction area CA1, and the like. FIG. 11 is a view showing the effective area DA, the second non-effective area UA2, the fourth non-effective area UA4, the eighth non-effective area UA8, the twelfth non-effective area UA12, the second correction area CA2, and the like.

As shown in FIG. 8 to FIG. 11, the photoelectric conversion substrate 2 includes a plurality of gate lines G1 located at least in the effective area DA. The plurality of gate lines G1 are further located in the correction area CA (first correction area CA1 and second correction area CA2) and extend continuously.

As shown in FIG. 8 and FIG. 9, the photoelectric conversion substrate 2 further includes gate lines G2 located in the third non-effective area UA3, the fifth non-effective area UA5, the seventh non-effective area UA7, the ninth non-effective area UA9, and the eleventh non-effective area UA11. In the embodiment, the photoelectric conversion substrate 2 includes two gate lines G2 in the third non-effective area UA3, the fifth non-effective area UA5, the seventh non-effective area UA7, the ninth non-effective area UA9, and the eleventh non-effective area UA11, but may include one gate line G2 or three or more gate lines G2.

Each of the gate lines G2 extends intermittently in the third non-effective area UA3, the fifth non-effective area UA5, the seventh non-effective area UA7, the ninth non-effective area UA9, and the eleventh non-effective area UA11. In other words, each of the gate lines G2 includes a plurality of divided lines. In this example, each gate line G2 is formed to be divided for each section between two adjacent data lines T. Since the amount of charge accumulated in each divided line of the gate line G2 can be made smaller than the amount of charge accumulated in the gate line G2 in a case where the line is continuous, this feature can contribute to suppressing electrostatic damage to the photoelectric conversion substrate 2, in the embodiment.

As shown in FIG. 10 and FIG. 11, the photoelectric conversion substrate 2 further includes gate lines G3 located in the fourth non-effective area UA4, the sixth non-effective area UA6, the eighth non-effective area UA8, the tenth non-effective area UA10, and the twelfth non-effective area UA12. The gate lines G1, the gate lines G2, and the gate lines G3 are simultaneously formed of the same material and are located in the same layer (between the insulating layer 21 and the insulating layer 22).

In the embodiment, the photoelectric conversion substrate 2 includes two gate lines G3 in the fourth non-effective area UA4, the sixth non-effective area UA6, the eighth non-effective area UA8, the tenth non-effective area UA10, and the twelfth non-effective area UA12, but may include one gate line G3 or three or more gate lines G3.

Each of the gate lines G3 extends intermittently in the fourth non-effective area UA4, the sixth non-effective area UA6, the eighth non-effective area UA8, the tenth non-effective area UA10, and the twelfth non-effective area UA12. In other words, each of the gate lines G3 includes a plurality of divided lines. In this example, each gate line G3 is formed to be divided for each section between two adjacent data lines T. Since the amount of charge accumulated in each divided line of the gate line G3 can be made smaller than the amount of charge accumulated in the gate line G3 in a case where the line is continuous, this feature can contribute to suppressing electrostatic damage to the photoelectric conversion substrate 2, in the embodiment.

As shown in FIG. 8 to FIG. 11, the photoelectric conversion substrate 2 includes a plurality of data lines T1 that are located at least in the effective area DA and that intersect the plurality of gate lines G1, G2, and G3. The plurality of data lines T1 are further located in a third non-active area UA3 and a fourth non-active area UA4 and extend continuously.

As shown in FIG. 8 and FIG. 10, the photoelectric conversion substrate 2 further includes data lines T2 located in the first non-effective area UA1, the fifth non-effective area UA5, and the sixth non-effective area UA6. In the embodiment, the photoelectric conversion substrate 2 includes two data lines T2 in the first non-effective area UA1, the fifth non-effective area UA5, and the sixth non-effective area UA6, but may include one data line T2 or may include three or more data lines T2.

Each of the data lines T2 extends continuously in the first non-effective area UA1, the fifth non-effective area UA5, and the sixth non-effective area UA6. In other words, each of the data lines T2 includes a plurality of divided lines. In this example, each data line T2 is formed to be divided for each section between two adjacent gate lines G. Since the amount of charge accumulated in each divided line of the data line T2 can be made smaller than the amount of charge accumulated in the data line T2 in a case where the line is continuous, this feature can contribute to suppressing electrostatic damage to the photoelectric conversion substrate 2, in the embodiment.

The photoelectric conversion substrate 2 further includes a plurality of data lines T4 located in the first correction area CA1, the ninth non-effective area UA9, and the tenth non-effective area UA10. Each of the data lines T4 extends continuously in the first correction area CA1, the ninth non-effective area UA9, and the tenth non-effective area UA10.

As shown in FIG. 9 and FIG. 11, the photoelectric conversion substrate 2 further includes data lines T3 located in the second non-effective area UA2, the seventh non-effective area UA7, and the eighth non-effective area UA8. In the embodiment, the photoelectric conversion substrate 2 includes two data lines T3 in the second non-effective area UA2, the seventh non-effective area UA7, and the eighth non-effective area UA8, but may include one data line T3 or may include three or more data lines T3.

Each of the data lines T3 extends continuously in the second non-effective area UA2, the seventh non-effective area UA7, and the eighth non-effective area UA8. In other words, each of the data lines T3 includes a plurality of divided lines. In this example, each data line T3 is formed to be divided for each section between two adjacent gate lines G. Since the amount of charge accumulated in each divided line of the data line T3 can be made smaller than the amount of charge accumulated in the data line T3 in a case where the line is continuous, this feature can contribute to suppressing electrostatic damage to the photoelectric conversion substrate 2, in the embodiment.

The photoelectric conversion substrate 2 further includes a plurality of data lines T5 located in the second correction area CA2, the eleventh non-effective area UA11, and the twelfth non-effective area UA12. Each of the data lines T5 extends continuously in the second correction area CA2, the eleventh non-effective area UA11, and the twelfth non-effective area UA12. The data lines T1, the data lines T2, the data lines T3, the data lines T4, and the data lines T5 are simultaneously formed of the same material and are located in the same layer (between the insulating layer 22 and the insulating layer 23).

As shown in FIG. 8 to FIG. 11, the plurality of TFTs 13a are located in the effective area DA. Each of the TFT 13a is electrically connected to one corresponding gate line G1 of the plurality of gate lines G1 and one corresponding data line T1 of the plurality of data lines T1.

The photoelectric conversion substrate 2 includes a plurality of thin film transistors 13b serving as a plurality of dummy switching elements and a plurality of thin film transistors 13c serving as a plurality of correction switching elements. The thin film transistors 13c function as second thin film transistors, and the thin film transistors 13b function as third thin film transistors. In the following descriptions, the thin film transistor 13b is referred to as TFT 13b, and the thin film transistor 13c is referred to as TFT 13c. The plurality of TFTs 13b and the plurality of TFTs 13c are provided above the basement 2a.

The plurality of TFTs 13b are located in the non-effective area UA. Each of the TFT 13b is provided in the vicinity of an intersection between a corresponding one of the gate lines G and a corresponding one of the data lines T, but is not electrically connected to the gate lines G and the data lines T.

The plurality of TFTs 13c are located in the correction area CA. Each of the TFT 13c is electrically connected to one corresponding gate line G of the plurality of gate lines G and one corresponding data line T of the plurality of data lines T. The plurality of TFTs 13c include a plurality of TFTs 13c1 serving as a plurality of first correction switching elements and a plurality of TFTs 13c2 serving as a plurality of second correction switching elements.

For example, the TFT 13a, the TFT 13b, the TFT 13c1, and the TFT 13c2 are simultaneously formed of the same material.

The plurality of TFTs 13c1 are located in the first correction area CA1. Each of the TFT 13c1 is electrically connected to one corresponding gate line G1 and one corresponding data line T4. The plurality of TFTs 13c2 are located in the second correction area CA2. Each of the TFT 13c2 is electrically connected to one corresponding gate line G1 and one corresponding data line T5.

The photoelectric conversion substrate 2 includes a plurality of bias lines BL1, a plurality of bias lines BL2, a plurality of bias lines BL3, a plurality of bias lines BL4, and a plurality of bias lines BL5, and a peripheral line WL located outside the non-effective area UA. The plurality of bias lines BL1, the plurality of bias lines BL2, the plurality of bias lines BL3, the plurality of bias lines BL4, and the plurality of bias lines BL5 are located between the insulating layer 24 and the insulating layer 25 (FIG. 3). The peripheral line WL is grounded.

The plurality of bias lines BL1 are located in the effective area DA, the third non-effective area UA3, and the fourth non-effective area UA4, extend in the column direction Y, and are electrically connected to the peripheral line WL. The plurality of bias lines BL2 are located in the first non-effective area UA1, the fifth non-effective area UA5, and the sixth non-effective area UA6, extend in the column direction Y, and are not electrically connected to the peripheral line WL. The plurality of bias lines BL3 are located in the second non-effective area UA2, the seventh non-effective area UA7, and the eighth non-effective area UA8, extend in the column direction Y, and are not electrically connected to the peripheral line WL. The plurality of bias lines BL4 are located in the first correction area CA1, the ninth non-effective area UA9, and the tenth non-effective area UA10, extend in the column direction Y, and are electrically connected to the peripheral line WL. The plurality of bias lines BL5 are located in the second correction area CA2, the eleventh non-effective area UA11, and the twelfth non-effective area UA12, extend in the column direction Y, and are electrically connected to the peripheral line WL.

Incidentally, in the embodiment, the TFT 13c1 is electrically connected to the bias line BL4, and the TFT 13c2 is electrically connected to the bias line BL5. However, the TFT 13c1 may not be electrically connected to the bias line BL4, and the TFT 13c2 may not be electrically connected to the bias line BL5.

In the embodiment, the photoelectric conversion substrate 2 includes two bias lines BL2 in the first non-effective area UA1, the fifth non-effective area UA5, and the sixth non-effective area UA6, but may include one bias line BL2 or may include three or more bias lines BL2. Similarly, the photoelectric conversion substrate 2 includes two bias lines BL3 in the second non-effective area UA2, the seventh non-effective area UA7, and the eighth non-effective area UA8, but may include one bias line BL3 or may include three or more bias lines BL3.

Incidentally, the bias lines BL1, BL2, BL3, BL4, and BL5 may not extend in the column direction Y but may extend in the row direction X.

The plurality of TFDs 15a are located in the effective area DA. Each of the TFD 15a is electrically connected to one corresponding TFT 13a of the plurality of TFTs 13a. In addition, each of TFD 15a is electrically connected to one corresponding bias line BL1 of the plurality of bias lines BL1. More specifically, in each of the TFD 15a, an anode is electrically connected to one corresponding bias line BL1, and a cathode is electrically connected to one corresponding TFT 13a.

The photoelectric conversion substrate 2 further includes a plurality of second thin film photodiodes 15b. The second thin film photodiode 15b is hereinafter referred to as TFD 15b. The plurality of TFDs 15b are located in the non-effective area UA. The plurality of TFDs 15b are provided above the basement 2a (FIG. 3).

Each of the TFD 15b is electrically connected to one corresponding TFT 13b of the plurality of TFTs 13b. In addition, each of the TFD 15b is not electrically connected to the plurality of bias lines BL. More specifically, in each of the TFD 15b, an anode is not electrically connected to the bias line BL, and a cathode is electrically connected to one corresponding TFT 13b.

The plurality of TFTs 13a, the plurality of TFTs 13c1, and the plurality of TFTs 13c2 arranged in the row direction X, among the plurality of TFTs 13a, the plurality of TFTs 13c1, and the plurality of TFTs 13c2, are electrically connected to one corresponding gate line G1 that extends in the effective area DA, the first correction area CA1, and the second correction area CA2, among the plurality of gate lines G.

The plurality of TFTs 13c1 arranged in the column direction Y, among the plurality of TFTs 13c1, are electrically connected to one corresponding data line T4 that extends in the first correction area CA1, the ninth non-effective area UA9, and the tenth non-effective area UA10, among the plurality of data lines T.

The plurality of TFTs 13c2 arranged in the column direction Y, among the plurality of TFTs 13c2, are electrically connected to one corresponding data line T5 that extends in the second correction area CA2, the eleventh non-effective area UA11, and the twelfth non-effective area UA12, among the plurality of data lines T.

Among the plurality of pixels P of the photoelectric conversion substrate 2, a pixel including the TFT 13a and the TFD 15a that are electrically connected to each other is referred to as an effective pixel Pv, a pixel including the TFT 13b and the TFD 15b that are electrically connected to each other is referred to as a non-effective pixel Pu, a pixel including the TFT 13c1 is referred to as a first correction pixel Pc1, and a pixel including the TFT 13c2 is referred to as a second correction pixel Pc2. The plurality of pixels P are arranged in a matrix in the row direction X and the column direction Y. For example, the effective pixel Pv is a pixel that is effective for detection of radiation (for example, X-rays).

The non-effective pixel Pu (TFT 13b) is not electrically connected to the gate line G1. Therefore, the rightmost first correction pixel Pc1 (TFT 13c1) is electrically continuous with the leftmost effective pixel Pv (TFT 13a). Similarly, the leftmost second correction pixel Pc2 (TFT 13c2) is electrically continuous with the rightmost effective pixel Pv (TFT 13a).

In the third non-effective area UA3, the fifth non-effective area UA5, and the seventh non-effective area UA7, a plurality of non-effective pixels Pu are arranged in two rows. The above-mentioned width Wup corresponds to the length in the column direction Y from the uppermost gate line G1 to the uppermost gate line G2.

In the third non-effective area UA3, the fifth non-effective area UA5, and the seventh non-effective area UA7, however, the plurality of non-effective pixels Pu may be arranged in only one row or may be arranged in three or more rows. When the plurality of non-effective pixels Pu are arranged in only one row, the above-mentioned width Wup is, for example, 150 µm.

In the fourth non-effective area UA4, the sixth non-effective area UA6, and the eighth non-effective area UA8, the plurality of non-effective pixels Pu are arranged in two rows.

In the fourth non-effective area UA4, the sixth non-effective area UA6, and the eighth non-effective area UA8, however, the plurality of non-effective pixels Pu may be arranged in only one row or may be arranged in three or more rows.

In the first non-effective area UA1, the fifth non-effective area UA5, and the sixth non-effective area UA6, the plurality of non-effective pixels Pu are arranged in two columns. The above-mentioned width Wlf corresponds to the length in the row direction X from the leftmost data line T1 to the leftmost data line T2.

In the first non-effective area UA1, the fifth non-effective area UA5, and the sixth non-effective area UA6, however, the plurality of non-effective pixels Pu may be arranged in only one column or may be arranged in three or more columns. When the plurality of non-effective pixels Pu are arranged in only one column, the above-mentioned width Wlf is, for example, 150 µm.

In the second non-effective area UA2, the seventh non-effective area UA7, and the eighth non-effective area UA8, the plurality of non-effective pixels Pu are arranged in two columns. The above-mentioned width Wri corresponds to the length in the row direction X from the leftmost data line T3 to the leftmost data line T5.

In the second non-effective area UA2, the seventh non-effective area UA7, and the eighth non-effective area UA8, however, the plurality of non-effective pixels Pu may be arranged in only one column or may be arranged in three or more columns.

The read circuit 11a, which serves as a drive circuit, is electrically connected to at least the gate lines G1 located in the effective area DA, among the gate lines G, and sequentially supplies control signals S1 to the gate lines G1. The read circuit 11a is not electrically connected to the plurality of gate lines G2 located in the third non-effective area UA3, the fifth non-effective area UA5, the seventh non-effective area UA7, the ninth non-effective area UA9, and the eleventh non-effective area UA11, and the plurality of gate lines G3 located in the fourth non-effective area UA4, the sixth non-effective area UA6, the eighth non-effective area UA8, the tenth non-effective area UA10, and the twelfth non-effective area UA12, among the gate lines G.

However, the read circuit 11a may be electrically connected to the plurality of gate lines G2 and the plurality of gate lines G3.

The plurality of TFTs 13c1 and the plurality of TFTs 13c2 can correct the control signals S1 supplied to the plurality of gate lines G1. By correcting the control signals S1, the image data signals S2 can be corrected.

The signal detection circuit 11b, which serves as a detection circuit, is electrically connected to at least the plurality of data lines T1 located in the effective area DA, among the plurality of data lines T, and can receive an image data signal S2 based on the electric charge converted by each of TFD 15a.

The signal detection circuit 11b is further electrically connected to a plurality of data lines T located in the correction area CA, among the plurality of data lines T. More specifically, the signal detection circuit 11b is further electrically connected to the plurality of data lines T4 located in the first correction area CA1 and the like, and the plurality of data lines T5 located in the second correction area CA2 and the like.

The signal detection circuit 11b is not electrically connected to the plurality of data lines T2 located in the first non-effective area UA1, the fifth non-effective area UA5, and the sixth non-effective area UA6, and the plurality of data lines T3 located in the second non-effective area UA2, the seventh non-effective area UA7, and the eighth non-effective area UA8, among the plurality of data lines T.

However, the signal detection circuit 11b may be electrically connected to the plurality of data lines T2 and the plurality of data lines T3.

The X-ray detector 1 according to the first embodiment is configured as described above.

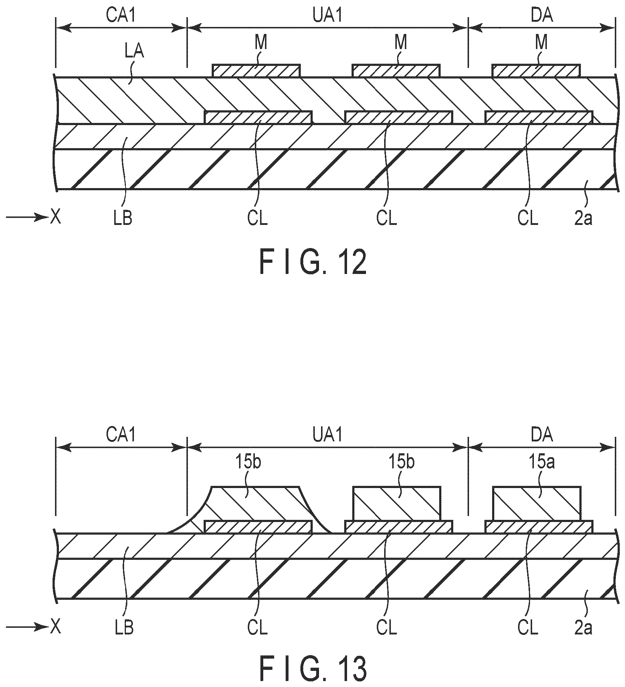

Next, a method of manufacturing the photoelectric conversion substrate 2 according to the first embodiment will be described. FIG. 12 is a view illustrating the method of manufacturing the photoelectric conversion substrate 2 according to the first embodiment, and is a cross-sectional view showing the basement 2a, an underlayer LB, the plurality of conductive layers CL, a laminate LA, and a plurality of resist masks M. FIG. 13 is a view illustrating the manufacturing method, following FIG. 12, and is a cross-sectional view showing the basement 2a, the underlayer LB, the plurality of conductive layers CL, and a plurality of TFDs 15a and 15b.

As shown in FIG. 12, when manufacturing the photoelectric conversion substrate 2 is started, first, the underlayer LB is formed on the basement 2a. The underlayer LB includes a laminated structure from the insulating layer 21 to the insulating layer 23 (FIG. 3). Next, a plurality of conductive layers CL are formed on the underlayer LB. Next, the laminate LA is formed on the underlayer LB and the plurality of conductive layers CL. In the embodiment, the laminate LA has a three-layer laminated structure. However, the laminate LA may have a laminated structure of four or more layer and may correspond to the type of TFDs 15a and 15b.

After that, a resist layer is formed on the laminate LA, and the resist layer is patterned. As a result, the plurality of resist masks M are formed on the laminate LA. Each of the resist masks M is superposed on the conductive layer CL and is located in the area where the TFD 15a or TFD 15b is to be formed.

Then, the laminate LA is etched by dry etching. As a result, the area of the laminate LA, which overlaps with the resist mask M, can be left. The resist masks M are then removed.

As shown in FIG. 13, the plurality of TFDs 15a and 15b are formed on the plurality of conductive layers CL. The plurality of TFDs 15a are formed desirably (uniformly) across the entire effective area DA. As a result, the plurality of TFDs 15a can detect the light made incident from the scintillator layer 5 under uniform conditions and convert the light into an electric charge.

Incidentally, during dry etching, etching may not be able to be desirably executed in the outer peripheral area of the area where the plurality of TFDs 15a and 15b are formed. For example, the etching gas does not easily reach the laminate LA on the outer peripheral side of the first non-effective area UA1, etching of the laminate LA becomes insufficient, and the TFD 15b on the first correction area CA1 side is formed to be undesirably large. The TFD 15b on the first correction area CA1 side may become too large, and the TFD 15b on the first correction area CA1 side may be formed continuously with the TFD 15b on the effective area DA side. It is difficult for the plurality of TFDs 15b to detect the light made incident from the scintillator layer 5 under uniform conditions and convert the light into an electric charge.

Incidentally, if the TFD 15b in the non-effective area UA is desirably etched, the TFD 15a in the center of the effective area DA may be over-etched.

However, the TFD 15b is a dummy thin film photodiode located in the non-effective area UA, and is not electrically connected to the gate line G, the data line T, or the bias line BL. In other words, the non-effective pixel Pu does not output an image data signal S2 based on the light detected by the TFD 15b. In addition, the electric charge generated by the TFD 15b does not adversely affect the image data signal S2 output by the effective pixel Pv.

After forming the plurality of TFDs 15a and 15b, the insulating layer 24, the bias line BL, the insulating layer 25, and the like are formed in this order. As a result, the photoelectric conversion substrate 2 is completed and manufacturing the photoelectric conversion substrate 2 is ended.

According to the X-ray detector 1 and the method of manufacturing the photoelectric conversion substrate 2 according to the first embodiment configured as described above, the photoelectric conversion substrate 2 comprises the basement 2a, the plurality of gate lines G, the plurality of data lines T, the plurality of TFTs 13a, the plurality of TFDs 15a, the plurality of TFDs 15b, and the plurality of TFTs 13c. Each of TFT 13a is electrically connected to one corresponding gate line G1 and one corresponding data line T1. Each of the TFD 15a is electrically connected to one corresponding TFT 13a. The plurality of TFDs 15b are located in a non-effective area UA in the non-detection area (first non-detection area NDA1), which is adjacent to the effective area DA. Each of TFT 13c is electrically connected to one corresponding gate line G1, and one corresponding data line T4 or one corresponding data line T5.

By forming the plurality of TFDs 15b around the effective area DA, the plurality of TFDs 15a can be desirably formed over the entire effective area DA. The photoelectric conversion substrate 2, the X-ray detection panel PNL, and the X-ray detection module 10 capable of uniformizing the photoelectric conversion efficiency of the plurality of TFDs 15a can be obtained.

The plurality of TFTs 13c comprise a function of correcting the image data signal S2. The TFT 13c can correct the signal in real time, and can remove or reduce noise in the signal detected by the effective pixels Pv. The image data signal S2 from which noise is removed or reduced can be obtained inside the photoelectric conversion substrate 2. The process of correcting the image data signal S2 outside the photoelectric conversion substrate 2 can be made unnecessary. As a result, photoelectric conversion substrate 2 capable of desirably corresponding to not only still image capturing, but also moving image capturing can be obtained.

### (Modified Example of First Embodiment)

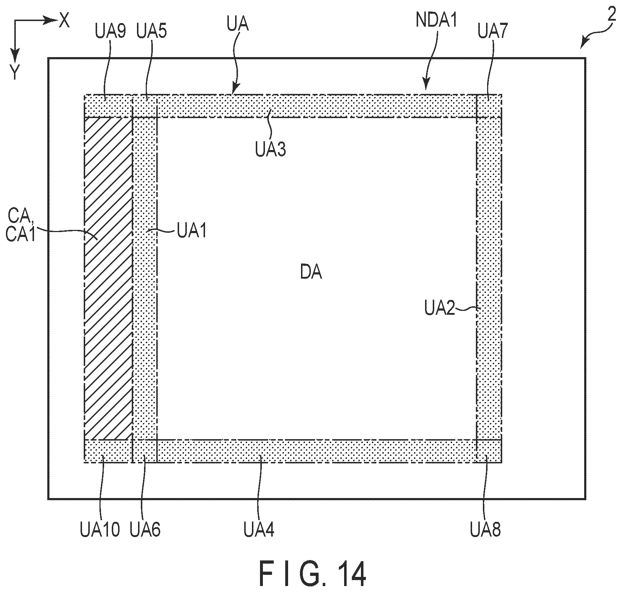

Next, the configuration of the X-ray detector 1 according to a modified example of the first embodiment will be described. The X-ray detector 1 has the same configuration as that of the above-described first embodiment except for constituent elements described in the modified example. FIG. 14 is a plan view showing a photoelectric conversion substrate 2 of the X-ray detection panel PNL according to the modified example, illustrating a positional relationship between a plurality of areas.

As shown in FIG. 14, the photoelectric conversion substrate 2 may be formed in the first non-detection area NDA1 without the second correction area CA2, the eleventh non-effective area UA11, and the twelfth non-effective area UA12. In other words, the non-effective pixels Pu (TFTs 13b and TFDs 15b) and the second correction pixels Pc2 (TFTs 13c2) may not be formed outside the second non-effective area UA2, the seventh non-effective area UA7, and the eighth non-effective area UA8 in the photoelectric conversion substrate 2.

In the modified example as well, the same advantages as those of the first embodiment can be obtained.

### (Second Embodiment)

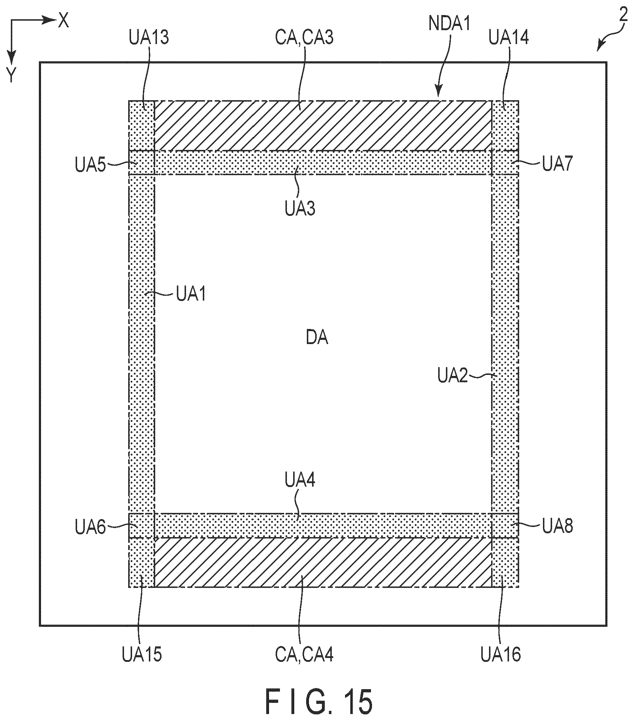

Next, the configuration of the X-ray detector 1 according to the second embodiment will be described. The X-ray detector 1 has the same configuration as that of the above-described first embodiment except for constituent elements described in the second embodiment. FIG. 15 is a plan view showing a photoelectric conversion substrate 2 of an X-ray detection panel PNL according to the second embodiment, illustrating a positional relationship between a plurality of areas. In FIG. 15, the non-effective area UA is marked with a dot pattern, and the correction area CA is marked with diagonal lines slanting upward to the right.

As shown in FIG. 15, the non-detection area (first non-detection area NDA1) does not include a ninth non-effective area UA9, a tenth non-effective area UA10, an eleventh non-effective area UA11, a twelfth non-effective area UA12, a first correction area CA1, and a second correction area CA2. The non-detection area (first non-detection area NDA1) further includes a thirteenth non-effective area UA13, a fourteenth non-effective area UA14, a fifteenth non-effective area UA15, a sixteenth non-effective area UA16, a third correction area CA3, and a fourth correction area CA4.

The correction area CA includes a third correction area CA3 and a fourth correction area CA4. The third correction area CA3 extends in the row direction X, is adjacent to the third non-effective area UA3 in the column direction Y, and sandwiches the third non-effective area UA3 in the column direction Y together with the effective area DA. The fourth correction area CA4 extends in the row direction X, is adjacent to the fourth non-effective area UA4 in the column direction Y, and sandwiches the fourth non-effective area UA4 in the column direction Y together with the effective area DA.

The non-effective area UA further includes the thirteenth non-effective area UA13, the fourteenth non-effective area UA14, the fifteenth non-effective area UA15, and the sixteenth non-effective area UA16.

The thirteenth non-effective area UA13 is adjacent to the fifth non-effective area UA5 in the column direction Y, and sandwiches the fifth non-effective area UA5 in the column direction Y together with the first non-effective area UA1. The fourteenth non-effective area UA14 is adjacent to the seventh non-effective area UA7 in the column direction Y, and sandwiches the seventh non-effective area UA7 in the column direction Y together with the second non-effective area UA2.

The fifteenth non-effective area UA15 is adjacent to the sixth non-effective area UA6 in the column direction Y, and sandwiches the sixth non-effective area UA6 in the column direction Y together with the first non-effective area UA1. The sixteenth non-effective area UA16 is adjacent to the eighth non-effective area UA8 in the column direction Y, and sandwiches the eighth non-effective area UA8 in the column direction Y together with the second non-effective area UA2.

Incidentally, the third correction area CA3 is further adjacent to the thirteenth non-effective area UA13 and the fourteenth non-effective area UA14, and is sandwiched between the thirteenth non-effective area UA13 and the fourteenth non-effective area UA14 in the row direction X. The fourth correction area CA4 is further adjacent to the fifteenth non-effective area UA15 and the sixteenth non-effective area UA16, and is sandwiched between the fifteenth non-effective area UA15 and the sixteenth non-effective area UA16 in the row direction X.

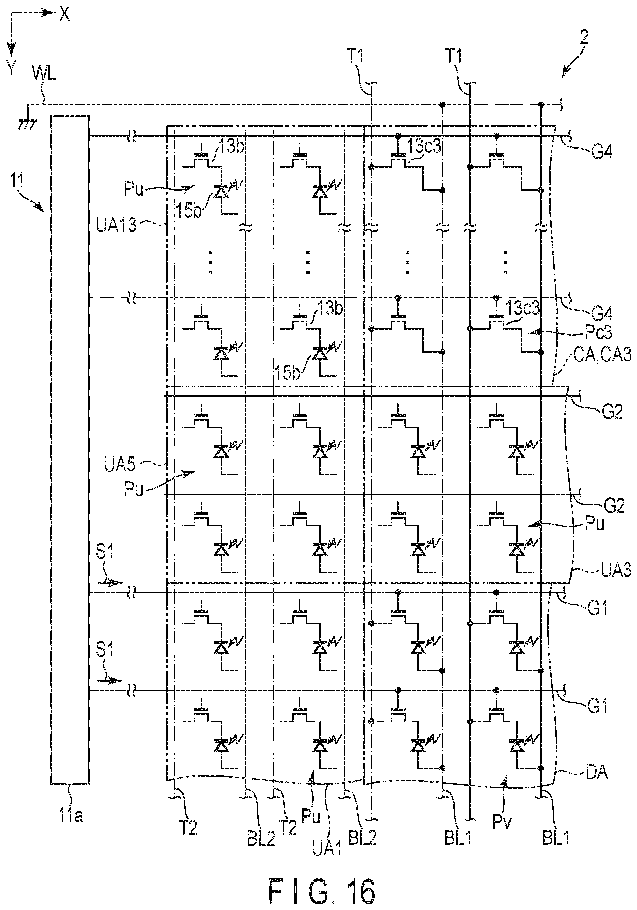

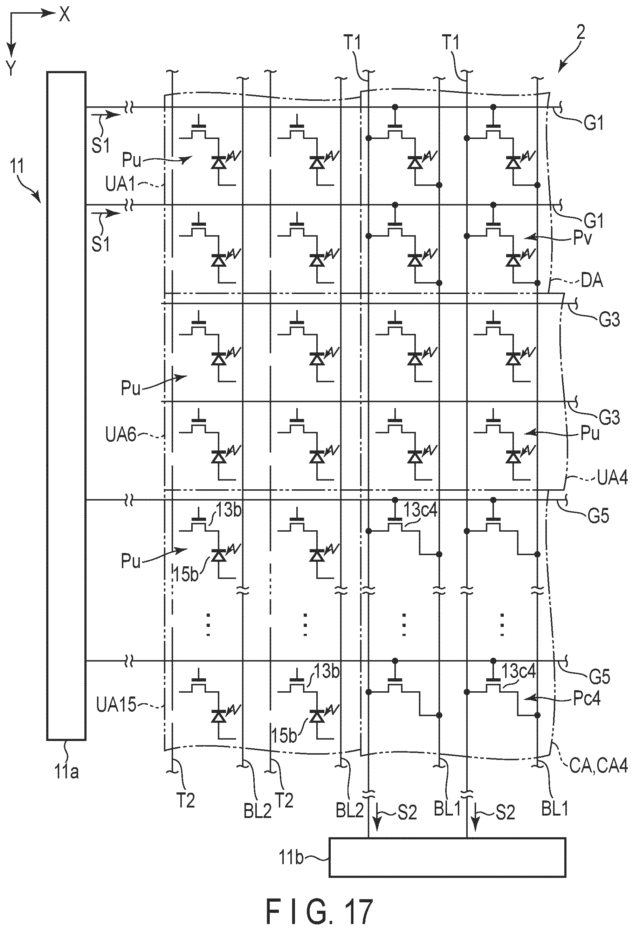

FIG. 16 and FIG. 17 are circuit diagrams showing the photoelectric conversion substrate 2 and the circuit board 11 of the X-ray detector 1 according to the second embodiment. FIG. 16 is a view showing the effective area DA, the first non-effective area UA1, the third non-effective area UA3, the fifth non-effective area UA5, the thirteenth non-effective area UA13, the third correction area CA3, and the like. FIG. 17 is a view showing the effective area DA, the first non-effective area UA1, the fourth non-effective area UA4, the sixth non-effective area UA6, the fifteenth non-effective area UA15, the fourth correction area CA4, and the like.

As shown in FIG. 15 to FIG. 17, the photoelectric conversion substrate 2 further includes a plurality of gate lines G4 located in the thirteenth non-effective area UA13, the fourteenth non-effective area UA14, and the third correction area CA3. The gate lines G4 extend continuously and are electrically connected to the read circuit 11a. The photoelectric conversion substrate 2 further includes a plurality of gate lines G5 located in the fifteenth non-effective area UA15, the sixteenth non-effective area UA16, and the fourth correction area CA4. The gate lines G5 extend continuously and are electrically connected to the read circuit 11a.

The plurality of TFTs 13c include a plurality of TFTs 13c3 serving as a plurality of third correction switching elements and a plurality of TFTs 13c4 serving as a plurality of fourth correction switching elements. The plurality of TFTs 13c3 are located in the third correction area CA3. Each of TFT 13c3 is electrically connected to one corresponding gate line G4 and one corresponding data line T1. The plurality of TFTs 13c4 are located in the fourth correction area CA4. Each of TFT 13c4 is electrically connected to one corresponding gate line G5 and one corresponding data line T1. In addition, the TFT 13c3 and the TFT 13c4 are electrically connected to a bias line BL1. Unlike the second embodiment, however, the TFT 13c3 and the TFT 13c4 may not be electrically connected to the bias line BL1.

Among the plurality of pixels P of the photoelectric conversion substrate 2, the pixel including the TFT 13c3 is referred to as a third correction pixel Pc3, and the pixel including the TFT 13c4 is referred to as a fourth correction pixel Pc4.

The non-effective pixel Pu (TFT 13b) is not electrically continuous with the data line T1. Therefore, the lowermost third correction pixel Pc3 (TFT 13c3) is electrically connected to the uppermost effective pixel Pv (TFT 13a). Similarly, the uppermost fourth correction pixel Pc4 (TFT 13c4) is electrically continuous with the lowermost effective pixel Pv (TFT 13a).

The plurality of TFTs 13c3 and the plurality of TFTs 13c4 can correct the image data signals S2 output to the plurality of data lines T.

The same advantages as those of the first embodiment can also be obtained from the X-ray detector 1 according to the second embodiment configured as described above.

### (Modified Example of Second Embodiment)

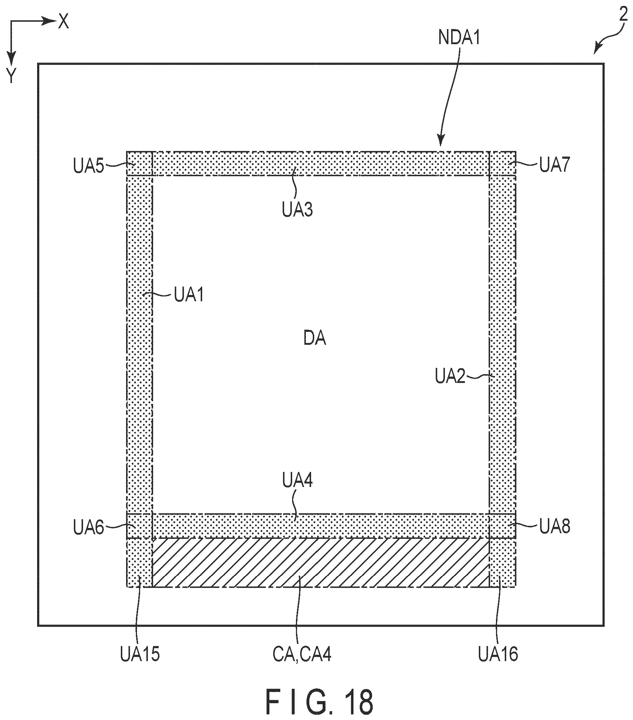

Next, the configuration of the X-ray detector 1 according to a modified example of the second embodiment will be described. The X-ray detector 1 has the same configuration as that of the above-described second embodiment except for constituent elements described in the modified example. FIG. 18 is a plan view showing a photoelectric conversion substrate 2 of the X-ray detection panel PNL according to the modified example, illustrating a positional relationship between a plurality of areas.

As shown in FIG. 18, the photoelectric conversion substrate 2 may be formed in the first non-detection area NDA1 without the third correction area CA3, the thirteenth non-effective area UA13, and the fourteenth non-effective area UA14. In other words, the non-effective pixels Pu (TFTs 13b and TFDs 15b) and the third correction pixels Pc3 (TFTs 13c3) may not be formed outside the third non-effective area UA3, the fifth non-effective area UA5, and the seventh non-effective area UA7 in the photoelectric conversion substrate 2.

In the modified example as well, the same advantages as those of the second embodiment can be obtained.

### (Third Embodiment)

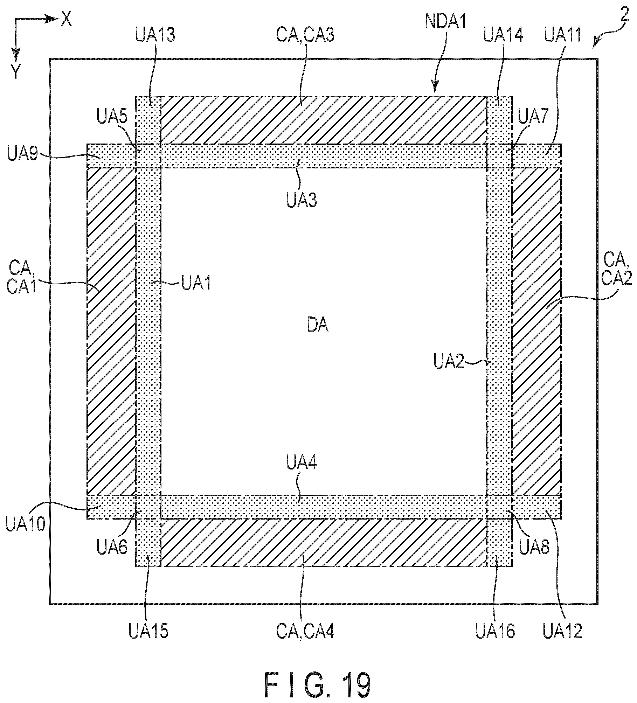

Next, the configuration of the X-ray detector 1 according to the third embodiment will be described. The X-ray detector 1 has the same configuration as that of the above-described first and second embodiments except for constituent elements described in the third embodiment. FIG. 19 is a plan view showing a photoelectric conversion substrate 2 of an X-ray detection panel PNL according to the third embodiment, illustrating a positional relationship between a plurality of areas. In FIG. 19, the non-effective area UA is marked with a dot pattern, and the correction area CA is marked with diagonal lines slanting upward to the right.

As shown in FIG. 19, the non-detection area (first non-detection area NDA1) may include a first non-effective area UA1 to a sixteenth non-effective area UA16, and a first correction area CA1 to a fourth correction area CA4. In the first correction area CA1 and the second correction area CA2, the plurality of TFTs 13c1 and the plurality of TFTs 13c2 can correct control signals S1 supplied to the plurality of gate lines G1. In the third correction area CA3 and the fourth correction area CA4, the plurality of TFTs 13c3 and the plurality of TFTs 13c4 can correct image data signals S2 output to the plurality of data lines T.

The same advantages as those of the first embodiment can also be obtained from the X-ray detector 1 according to the third embodiment configured as described above.

### (Modified Example of Third Embodiment)

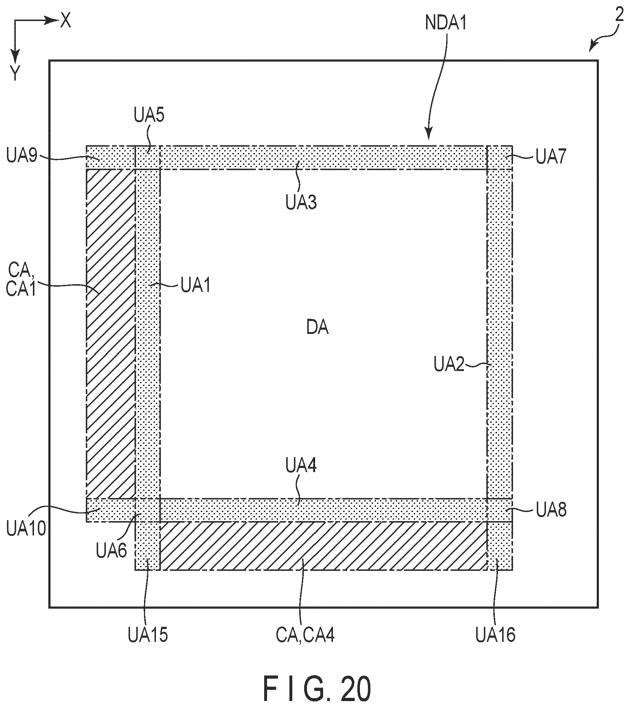

Next, the configuration of the X-ray detector 1 according to a modified example of the third embodiment will be described. The X-ray detector 1 has the same configuration as that of the above-described third embodiment except for constituent elements described in the modified example. FIG. 20 is a plan view showing a photoelectric conversion substrate 2 of the X-ray detection panel PNL according to the modified example, illustrating a positional relationship between a plurality of areas.

As shown in FIG. 20, the photoelectric conversion substrate 2 may be formed in the first non-detection area NDA1 without the second correction area CA2, the eleventh non-effective area UA11, the twelfth non-effective area UA12, the third correction area CA3, the thirteenth non-effective area UA13, and the fourteenth non-effective area UA14. In other words, the non-effective pixels Pu (TFTs 13b and TFDs 15b), the second correction pixels Pc2 (TFTs 13c2), and the third correction pixels Pc3 (TFTs 13c3) may not be formed outside the fifth non-effective area UA5, the seventh non-effective area UA7, the eighth non-effective area UA8, the ninth non-effective area UA9, and the sixteenth non-effective area UA16 in the photoelectric conversion substrate 2.

In the modified example as well, the same advantages as those of the third embodiment can be obtained.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

For example, the above-described technology is not limited to application to the X-ray detection panel PNL, the X-ray detection module 10, and the X-ray detector 1, but can be applied to various radiation detection panels such as other X-ray detection panels, various radiation detection modules such as other X-ray detection modules, and various radiation detectors such as other X-ray detectors. The radiation detector may comprise a radiation detection panel that detects radiation instead of the X-ray detection panel PNL.

## Claims

1. A photoelectric conversion substrate comprising:
a basement located in an effective area which is effective for detection of radiation, a frame-shaped non-effective area surrounding the effective area, and a correction area outside the non-effective area;
a plurality of gate lines provided above the basement and extending in a first direction;
a plurality of data lines provided above the basement, intersecting the plurality of gate lines, and extending in the second direction;
a plurality of first thin film transistors provided above the basement and located in the effective area, each of the first thin film transistors being electrically connected to one corresponding gate line of the plurality of gate lines and one corresponding data line of the plurality of data lines;
a plurality of first thin film photodiodes provided above the basement and located in the effective area, each of the plurality of first thin film photodiodes being electrically connected to one corresponding first thin film transistor of the plurality of first thin film transistors;
a plurality of second thin film photodiodes provided above the basement and located in the non-effective area; and
a plurality of second thin film transistors provided above the basement and located in the correction area, each of the second thin film transistors being electrically connected to one corresponding gate line of the plurality of gate lines and one corresponding data line of the plurality of data lines.

2. The photoelectric conversion substrate of claim 1, wherein
the non-effective area includes:
a first non-effective area and a second non-effective area each extending in the second direction, being adjacent to the effective area, and sandwiching the effective area in the first direction; and
a third non-effective area and a fourth non-effective area each extending in the first direction, being adjacent to the effective area, and sandwiching the effective area in the second direction.

3. The photoelectric conversion substrate of claim 2, wherein
the gate line located in the third non-effective area, among the plurality of gate lines, intermittently extends in the third non-effective area,
the gate line located in the fourth non-effective area, among the plurality of gate lines, intermittently extends in the fourth non-effective area,
the data line located in the first non-effective area, among the plurality of data lines, intermittently extends in the first non-effective area, and
the data line located in the second non-effective area, among the plurality of data lines, intermittently extends in the second non-effective area.

4. A radiation detection panel comprising:
a photoelectric conversion substrate; and
a scintillator layer, wherein
the photoelectric conversion substrate includes:
a basement located in an effective area which is effective for detection of radiation, a frame-shaped non-effective area surrounding the effective area, and a correction area outside the non-effective area;
a plurality of gate lines provided above the basement and extending in a first direction;
a plurality of data lines provided above the basement, intersecting the plurality of gate lines, and extending in the second direction;
a plurality of first thin film transistors provided above the basement and located in the effective area, each of the first thin film transistors being electrically connected to one corresponding gate line of the plurality of gate lines and one corresponding data line of the plurality of data lines;
a plurality of first thin film photodiodes provided above the basement and located in the effective area, each of the plurality of first thin film photodiodes being electrically connected to one corresponding first thin film transistor of the plurality of first thin film transistors;
a plurality of second thin film photodiodes provided above the basement and located in the non-effective area; and
a plurality of second thin film transistors provided above the basement and located in the correction area, each of the second thin film transistors being electrically connected to one corresponding gate line of the plurality of gate lines and one corresponding data line of the plurality of data lines, and
the scintillator layer is provided on the photoelectric conversion substrate and is located in the effective area.

5. The radiation detection panel of claim 4, further comprising:
a light reflective layer provided on the scintillator layer and located in the effective area.

6. The radiation detection panel of claim 5, further comprising:
a moisture-proof cover provided on the photoelectric conversion substrate, the scintillator layer, and the light reflective layer, located in the effective area and the non-effective area, and sealing the scintillator layer and the light reflective layer together with the photoelectric conversion substrate.

7. A radiation detection module comprising:
a photoelectric conversion substrate;
a drive circuit; and
a detection circuit,
wherein
the photoelectric conversion substrate includes:
a basement located in an effective area which is effective for detection of radiation, a frame-shaped non-effective area surrounding the effective area, and a correction area outside the non-effective area;
a plurality of gate lines provided above the basement and extending in a first direction;
a plurality of data lines provided above the basement, intersecting the plurality of gate lines, and extending in the second direction;
a plurality of first thin film transistors provided above the basement and located in the effective area, each of the first thin film transistors being electrically connected to one corresponding gate line of the plurality of gate lines and one corresponding data line of the plurality of data lines;
a plurality of first thin film photodiodes provided above the basement and located in the effective area, each of the plurality of first thin film photodiodes being electrically connected to one corresponding first thin film transistor of the plurality of first thin film transistors;
a plurality of second thin film photodiodes provided above the basement and located in the non-effective area; and
a plurality of second thin film transistors provided above the basement and located in the correction area, each of the second thin film transistors being electrically connected to one corresponding gate line of the plurality of gate lines and one corresponding data line of the plurality of data lines,
the drive circuit is electrically connected to at least a plurality of gate lines located in the effective area, among the plurality of gate lines, and supplies control signals to the plurality of gate lines located in the effective area,
the detection circuit is electrically connected to at least a plurality of data lines located in the effective area, among the plurality of data lines, and receives image data signals based on electric charges converted at the plurality of first thin film photodiodes, and
the plurality of second thin film transistors comprise a function of correcting the image data signals.
